# EUROPEAN PATENT APPLICATION

(11) **EP 4 622 102 A1**
(43) Date of publication of application: **24.09.2025**
(21) Application number: 25162977.0
(22) Date of filing: 11.03.2025
(51) Int. Cl.: H03F 3/45, H03F 1/48

(54) **SYSTEMS AND METHODS FOR HIGH ACCURACY OPEN LOOP TRANSCONDUCTANCE AMPLIFIER HAVING GAIN SET BY OUTPUT LOAD**

(30) Priority: 19.03.2024 US 202418609004
(71) Applicant: NXP USA, Inc., Austin, TX 78735 (US)
(72) Inventor: Newlin, Trevor Mark, 5656AG Eindhoven (NL)
(74) Representative: Krott, Michel

(57) **Abstract**

Some examples of the disclosure are directed to systems and methods for calibrating and operating transconductance amplifiers for high-bandwidth applications configured in open loop configurations. Some examples of the disclosure are directed to setting a gain of the transconductance amplifiers based upon a value of an output load. Some examples of the disclosure are directed to using auto-zeroing circuitry and gain correction circuitry to modify a biasing of a transconductance amplifier.

## Description

### Field of the Disclosure

This relates generally to systems and methods for continuous operation of transconductance amplifiers.

### Background of the Disclosure

Transconductance amplifiers are typically used to convert voltage to current signals, and are often implemented in the context of electronic devices such as switched-mode converters and power supplies. Conventional transconductance amplifiers designs, however, often cannot support applications requiring high-bandwidth and rapid transient responses without unreasonably expanding a footprint of circuitry implementing such amplifiers. Thus, a transconductance amplifier topology that reduces circuit board area and supports both high-bandwidth and high slew-rate implementations is desired.

### Summary of the Disclosure

This relates generally to devices and/or systems including transconductance amplifiers configured to support high-bandwidth, and rapid output swing requirements. For example, the transconductance amplifiers can operate in parallel and be configured for systems with a threshold bandwidth requirement (e.g., greater than 10 MHz, 20 MHz, 50 MHz, etc. bandwidth) and/or with a threshold rise time requirement (e.g., less than 0.25, 0.5, 0.75, 1, 1.25, 1.5, or 3 ns). In particular, a plurality of transconductance amplifiers can be configured to (i) convert an input voltage to an output current in a transconductance phase and/or to (ii) perform one or more calibration operations in one or more phases, including an auto-zeroing subphase and a gain offset correction subphase (also referred to herein as a gain correction subphase).

In some embodiments, a dual amplifier architecture is employed. While a first amplifier performs the operations associated with (i) transconductance (e.g., converting a voltage to a current), a second amplifier performs operations associated with the (ii) one or more calibration phase(s). The plurality of transconductance amplifiers can be configured in an open loop configuration, and can reduce input offset and modify amplifier gain to support systems requiring the threshold bandwidth and/or transient requirements. For example, during a first period of time, a first transconductance amplifier is configured to operate as the voltage-to-current converter between a shared the input and output of the dual amplifier, and a second transconductance amplifier is configured to perform the one or more calibration phases (e.g., an auto-zeroing subphase followed by a gain offset correction subphase) while decoupled from the shared input and output of the dual amplifier. During a second period of time, the operation of each amplifier of the dual amplifier is reversed. The first transconductance amplifier is configured to perform the one or more calibration phases while the second transconductance amplifier operates as the voltage-to-current converter between a shared the input and output of the dual amplifier. During the first period of time and second period of time, a respective one of the first and second transconductance amplifiers is coupled between first input nodes and an output node, such that the respective of the first transconductance amplifier or the second transconductance amplifier is configured to perform a transconductance measurement with respect to the same input nodes and output node, while the other amplifier is performing the one or more calibration phases while decoupled from the input node and output node of the respective amplifier. In some embodiments, the dual amplifier uses input and output switching to achieve calibration (e.g., auto-zero and gain offset correction) on every other clock cycle.

The full descriptions of these examples are provided in the Drawings and the Detailed Description, and it is understood that this Summary does not limit the scope of the disclosure in any way.

### Brief Description of the Drawings

For improved understanding of the various examples described herein, reference should be made to the Detailed Description below along with the following drawings. Like reference numerals often refer to corresponding parts throughout the drawings.
FIG. 1 illustrates an example flowchart of a method of configuring a transconductance amplifier to calibrate and operate according to embodiments of the disclosure.
FIG. 2 illustrates a transconductance amplifier topology according to embodiments of the disclosure.
FIG. 3 illustrates a transconductance amplifier topology according to embodiments of the disclosure.
FIG. 4 illustrates a timing diagram of a plurality of input switches and a plurality of output switches according to embodiments of the disclosure.
FIG. 5 illustrates a timing diagram of a transconductance amplifier topology according to embodiments of the disclosure.
FIG. 6 illustrates switching configurations of a transconductance amplifier topology according to embodiments of the disclosure.
FIG. 7 illustrates control circuitry for controlling a transconductance amplifier topology according to embodiments of the disclosure.
FIG. 8 illustrates a transconductance amplifier topology including auto-zero circuitry according to embodiments of the disclosure.
FIG. 9 illustrates a transconductance amplifier topology including gain correction circuitry according to embodiments of the disclosure.

### Detailed Description

This relates generally to devices and/or systems including transconductance amplifiers configured to support high-bandwidth, and rapid output swing requirements. For example, the transconductance amplifiers can operate in parallel and be configured for systems with a threshold bandwidth requirement (e.g., greater than 10 MHz, 20 MHz, 50 MHz, etc. bandwidth) and/or with a threshold rise time requirement (e.g., less than 0.25, 0.5, 0.75, 1, 1.25, 1.5, or 3 ns). In particular, a plurality of transconductance amplifiers can be configured to (i) convert an input voltage to an output current in a transconductance phase and/or to (ii) perform one or more calibration operations in one or more phases, including an auto-zeroing subphase and a gain offset correction subphase (also referred to herein as a gain correction subphase).

In some embodiments, a dual amplifier architecture is employed. While a first amplifier performs the operations associated with (I) transconductance (e.g., converting a voltage to a current), a second amplifier performs operations associated with the (ii) one or more calibration phase(s). The plurality of transconductance amplifiers can be configured in an open loop configuration, and can reduce input offset and modify amplifier gain to support systems requiring the threshold bandwidth and/or transient requirements. For example, during a first period of time, a first transconductance amplifier is configured to operate as the voltage-to-current converter between a shared the input and output of the dual amplifier, and a second transconductance amplifier is configured to perform the one or more calibration phases (e.g., an auto-zeroing subphase followed by a gain offset correction subphase) while decoupled from the shared input and output of the dual amplifier. During a second period of time, the operation of each amplifier of the dual amplifier is reversed. The first transconductance amplifier is configured to perform the one or more calibration phases while the second transconductance amplifier operates as the voltage-to-current converter between a shared the input and output of the dual amplifier. During the first period of time and second period of time, a respective one of the first and second transconductance amplifiers is coupled between first input nodes and an output node, such that the respective of the first transconductance amplifier or the second transconductance amplifier is configured to perform a transconductance measurement with respect to the same input nodes and output node, while the other amplifier is performing the one or more calibration phases while decoupled from the input node and output node of the respective amplifier. In some embodiments, the dual amplifier uses input and output switching to achieve calibration (e.g., auto-zero and gain offset correction) on every other clock cycle.

In the embodiments described herein, it is understood that the singular forms (e.g., "a," "an," and "the") used in the following description are intended to also include the plural forms, unless the context clearly indicates otherwise. It is also understood that the term "and/or" used in the following description are intended to and encompasses any and all possible combinations of one or more of the associated listed items. It is further understood that the terms "includes, "including," "comprises," and/or "comprising," used in the following description are intended to specify the presence of stated features, integers, steps, operations, elements, components, and/or units but do not preclude the presence or addition of one or more other features, integers, steps, operations, elements, components, units, and/or groups thereof.

Certain aspects of the present disclosure include process steps, operations, and/or instructions described herein. It is understood that the process steps, instructions, and/or operations of the present disclosure may be embodied in software, firmware, and/or hardware. When embodied in software, the process steps, instructions, and/or operations of the present disclosure may be downloaded to reside on and be operated from different platforms used by a variety of operating systems.

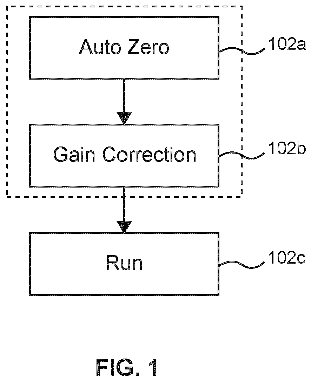

It is understood that an example device including the circuitry described herein, and/or in communication with the circuitry described herein, can be contemplated without departing from the scope of the present disclosure. For example, the device optionally is a switched-mode power supply, a power management integrated circuit, an application specific integrated circuit, a solution-on-chip, a circuit board including various integrated circuits and/or the like including the switching circuitry, amplifiers, interconnects, and/or passive components described herein. The device can include logical storage, such as electrical, magnetic, and/or optical memory (e.g., including random access memory, a cache, a hard drive, and/or other non-transitory computer readable mediums). The device can include interfacing circuitry to detect, monitor, buffer, and/or store measurements of current, voltage, and the like at various nodes included in the circuitry. In some embodiments, the storage stores one or more instructions, including instructions to configure switches, sequence switches, vary voltages, vary currents, bias circuitry, route inputs to and outputs from amplifiers, and the like in order to perform one or more operations described at least with reference to FIGs. 1-9. In some embodiments, the circuitry disclosed herein can be at least partially distributed amongst a plurality of devices, such as between a plurality of integrated circuits.

FIG. 1 illustrates an example flowchart of a method of configuring a transconductance amplifier to perform calibration in one or more phases and transconductance operation according to embodiments of the disclosure. For example, a transconductance amplifier performs one or more calibration phases, including performing an auto-zeroing operation (102a) during an auto-zeroing subphase and a gain correction operation during a gain correction subphase (102b). After the one or more calibration operations, the transconductance amplifier performs a transconductance operation (102c) as a run-time measurement. As described herein, it is understood that conventional transconductance amplifier topologies often suffer from insufficient bandwidth and/or insufficient transient characteristics required for high-current (e.g., 5, 10, 20, 30, 40, or 50A), high-speed, and/or high-temperature operations (e.g., stable from -50C to 200C). For example, performing the above mentioned one or more calibration operations in a calibration phase followed by the transconductance operation reduces the bandwidth and/or requires many switching operations in the signal path that may introduce transients.

The methods and devices described herein relate to a parallel transconductance amplifier topology in which different amplifiers are configured for performing different operation in parallel. This parallel operation enables continuous operation of at least one amplifier for transconductance operation, whereas calibration of another amplifier can be performed in parallel without impacting the transconductance operation. For example, for a dual amplifier, during a first period of time, a first amplifier performs transconductance operations in which a measured input voltage is converted to an output current (e.g., the first amplifier is configured in an operational mode during the first period of time to perform transconductance operation (102c)) while a second amplifier is configured to perform one or more calibration operations (e.g., the second amplifier configured in a calibration mode during the first period of time to perform auto-zeroing operation (102a) and gain correction operation (102b)). During a second period of time, different from the first period of time, the operations of the first and second amplifiers are reversed. The first amplifier is configured to perform the one or more calibration operations (auto-zeroing operation (102a) and gain correction operation (102b)) while the second amplifier is configured to perform transconductance operations (transconductance operation (102c)).

FIG. 1, therefore, illustrates the calibration and operational phases of a respective amplifier of the dual, parallel transconductance amplifier topology, but it is understood that the other amplifier in parallel with the respective amplifier is configured with to perform the same operations with an offset in time (e.g., the other amplifier performs transconductance operations while the respective amplifier is performing one or more calibration operations, or performing one or more calibration operations while the respective amplifier is operating). It is further understood that additional amplifiers (e.g., more than two) can be configured in parallel with at least one amplifier configured to perform transconductance operations in an operational phase, and that the additional amplifiers in parallel perform one or more of the calibration subphases descried herein while the operational phase amplifier measures transconductance. For example, for a tri-amplifier transconductance amplifier topology, during a first time period, a first amplifier is configured to perform transconductance operations, a second amplifier is configured to perform autozeroing operations, and a third amplifier is configured to perform gain correction operations. During a second time period, the third amplifier is configured to perform transconductance operations, the first amplifier is configured to perform autozeroing operations, and the second amplifier is configured to perform gain correction operations. During a third time period, the second amplifier is configured to perform transconductance operations, the third amplifier is configured to perform autozeroing operations, and the first amplifier is configured to perform gain correction operations. Additionally, it is understood that increasing the number of parallel amplifiers enables some of the amplifiers to idle while other amplifiers are performing the operations of FIG. 1. Additionally, it is understood, that although described as nonoverlapping phases, increasing the number of amplifiers enables for some overlap between the auto-zeroing subphase, the gain correction sub-phase, and the measurement subphase applied at different amplifiers.

The auto-zeroing subphase is used to mitigate undesirable drift of a transconductance amplifier. For example, a natural offset voltage exists and/or develops between terminals of a transconductance amplifier configured in an open loop configuration. The offset voltage can undesirably change or impact one or more characteristics of the transconductance amplifier, such as amplification characteristics. In some embodiments, the auto-zeroing subphase can limit an input offset voltage between input terminals of an amplifier, such that the voltage across a load that is coupled to the amplifier output is less than a threshold voltage.

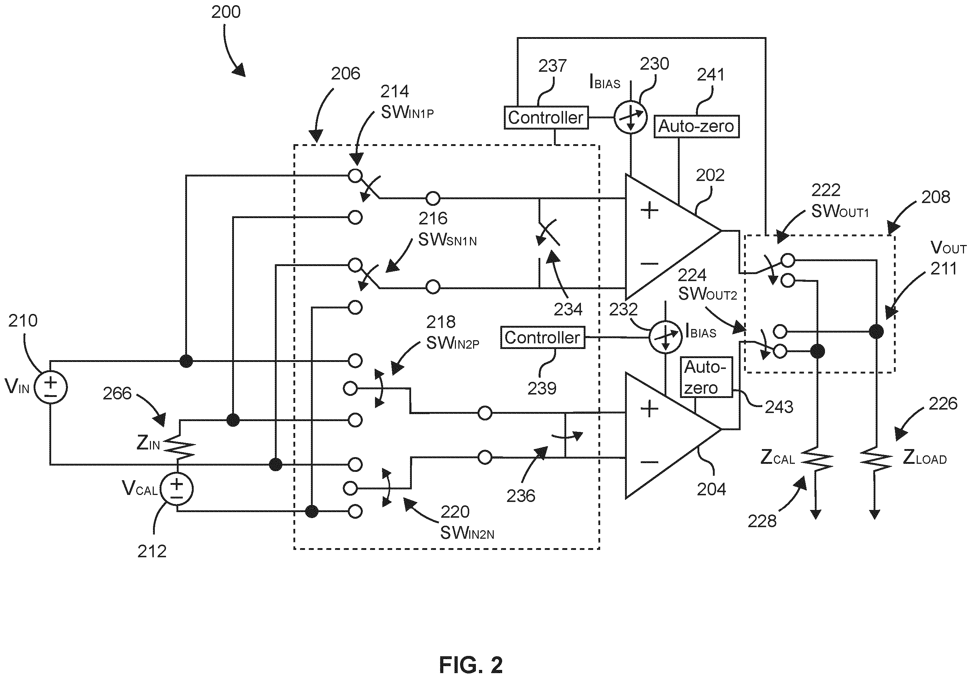

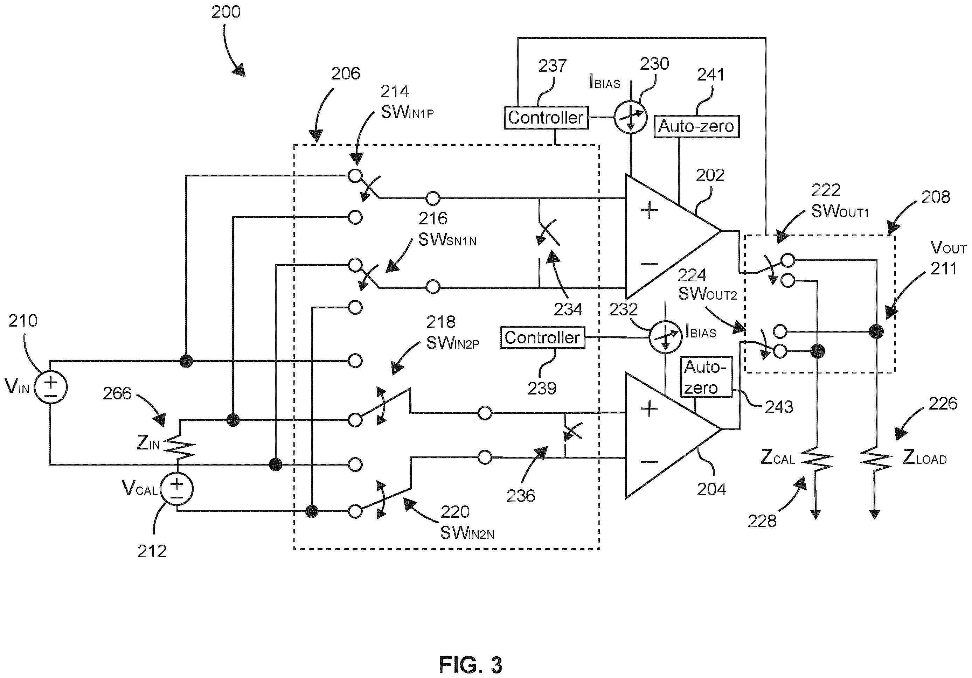

FIG. 2-3 illustrate a transconductance amplifier topology according to embodiments of the disclosure with a first amplifier configured for transconductance operation and a second amplifier configured for autozeroing operation (in FIG. 2) or gain correction operation (in FIG. 3). Switching circuitry enables configuration of the first amplifier or second amplifier for the aforementioned operations. For example, switching circuitry included in the transconductance amplifier topology (or in a device including the transconductance amplifier topology) is configured in a first configuration. In the first configuration, one or more input switches and one or more output switches, such as input switches 206 and output switches 208 illustrated in FIG. 2, are arranged to couple the first amplifier 202 between the input and output of the transconductance amplifier topology. For example, the input represented by V_{IN} 210 is coupled differentially to the input terminals of amplifier 202 using switches 214 and 216 (e.g., single pole, double throw switches); the output, represented by V_{OUT} 211 is coupled to the output terminal of amplifier 202 using switch 222 and coupled to output load 226 (Z_{LOAD}). The first amplifier remains in the same configuration shown in FIG. 3.

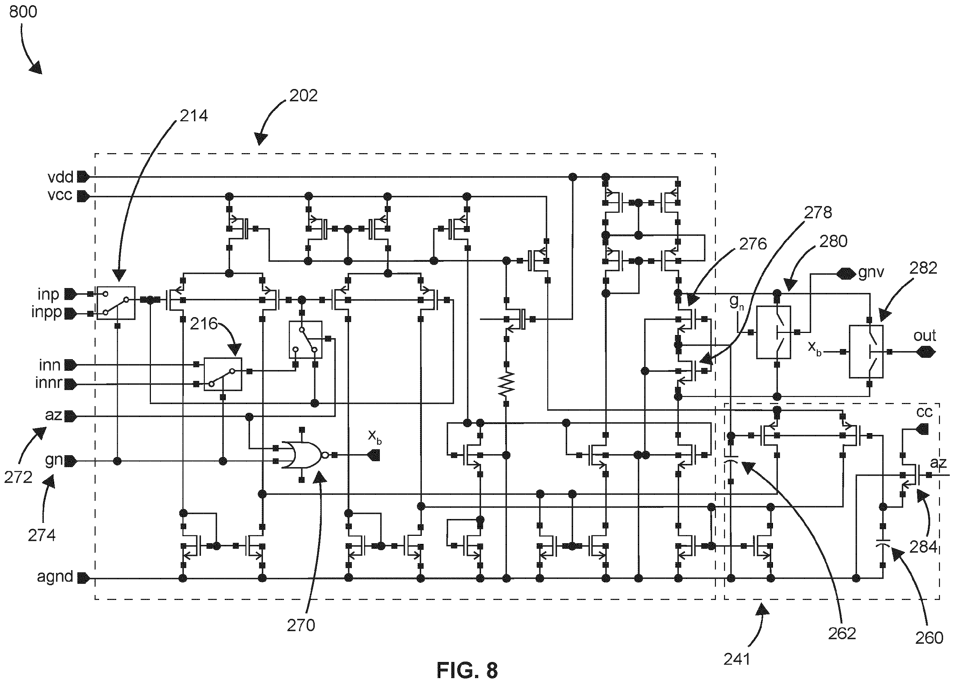

As shown in FIG. 2, during the auto-zeroing operation, one or more input switches, such as switch 236, are arranged to couple (e.g., short) the input terminals of the second amplifier 204 illustrated in FIG. 2. Further, in the first configuration, one or more output switches included in the switching circuitry can be configured to couple the output of the second amplifier 204 to an auto-zero amplifier. For example, as shown in FIG. 2, second amplifier 204 is coupled to auto-zero amplifier 243 (or another auto-zero amplifier such as auto-zero amplifier 243 or auto zero amplifier 241) and to one or more compensation capacitors (e.g., capacitors 260, 262 in FIG. 8, not shown in FIG. 2 for ease of illustration).

The auto-zero amplifier works to auto-zero the output to the working output voltage of the second amplifier 204 while the inputs of the second amplifier 204 are shorted. Balancing the auto-zero amplifier causes the compensation capacitors associated with auto-zero amplifier to store charge by a correction current (CC). For example, FIG. 8 illustrates a transistor-level circuit schematic of an example amplifier 202 with an example auto-zero amplifier 241. Capacitor 262 and/or capacitor 260 illustrated in FIG. 8 can charge while the inputs of the first amplifier 202 are shorted together (e.g., when switch 214 and switch 216 in FIG. 8 short input terminals of a differential pair). A control signal coupled to an autozero terminal 272 may also enable one or more switches, such as switch 276, switch 278, and/or switch 284. The combination of transistors and/or passive circuitry (e.g., resistors, capacitors) and/or logic gates cause capacitors 260 and 262 to charge as the voltage offset between the inputs of the differential pairs reduces (e.g., to 0V, or within a threshold voltage of 0V, such as less than 100nV, 1µV, 500 µV, 1 mV, etc.). Thus, the auto-zero electronic device 200 can adjust biasing of a transconductance amplifier until one or more criteria are satisfied, including a criterion that is satisfied when the voltage offset between the inputs of the transconductance amplifier is less than a threshold level. Thus, in this first configuration, the device can determine a correction capacitance (e.g., provided via the auto-zero amplifier coupled to compensation capacitors 260 and/or 262) in order to minimize (or zero) the input offset for the second amplifier 204. After the auto-zeroing operation is completed, the compensation capacitors are partially decoupled, but hold the correction voltage for to maintain the input offset at or near zero for the gain correction operation. In some embodiments, the auto-zero amplifier is a Class B amplifier, such that quiescent current is reduced (e.g., zero, or near zero) while reducing the input offset of second amplifier 204.

In some embodiments, transconductance of a transconductance amplifier can differ from a nominal value due to drift of the amplifier and/or other circuitry biasing the amplifier. To mitigate the drift, and optionally after performing the auto-zero calibration subphase, the device performs a gain correction (102b) during the gain correction subphase. The gain correction subphase-included as a subphase of the one or more calibration phases-includes modifying the biasing of the transconductance amplifier (e.g., a current bias I_{BIAS}), thereby modifying the gain of the amplifier. For example, FIG. 3 illustrates a second configuration for biasing the second amplifier 204 using biasing circuitry 232. The switches for first amplifier 202 remain the same in the second configuration as in the first configuration. In some embodiments, the transconductance amplifier is biased using analog circuitry, such as analog circuitry that detects a gain offset, and provides analog feedback to the transconductance amplifier based upon operating conditions detected during a closed-loop calibration subphase. In some embodiments, the transconductance amplifier is biased using a current source controlled by a controller, such as controller 239. The device can configure the switching circuitry in a different configuration (second configuration) for gain correction than the configuration required to perform auto-zero calibration. The different configuration can include coupling the inputs of the second amplifier 204 to a reference voltage (e.g., 10mV corresponding to the V_{cal} 212 in FIG. 2-3), coupling an output of the transconductance amplifier to an output load (e.g., an attenuation network, such as a network including the load 226 and the calibration load 228), and measuring a difference between the voltage formed across the output load and a target voltage.

In some embodiments, V_{cal} 212 and/or resistor 266 are representative of one or more semiconductor devices (e.g., field effect transistors (FETs), bipolar junction transistors (BJTs), thyristors, and the like) and/or one or more passive devices (e.g., resistors, capacitors, and/or inductors) configured to generate a calibration voltage across the terminals of the second amplifier 204. In some embodiments, V_{cal} 212 and resistor 266 are representative of an input attenuation network (e.g., a ladder of a plurality of resistors) that taps a reference voltage (e.g., a voltage supply rail coupled to the electronic device 200). In some embodiments, V_{cal} 212 corresponds to an input voltage (e.g., 1, 5, 10, 15, 30, or 50mV) that can be coupled across the terminals of a transconductance amplifier for a gain correction subphase included in the calibration phase (e.g., different from an auto-zeroing subphase), which can be predetermined based upon different implementations and/or operating conditions required by electronic device 200.

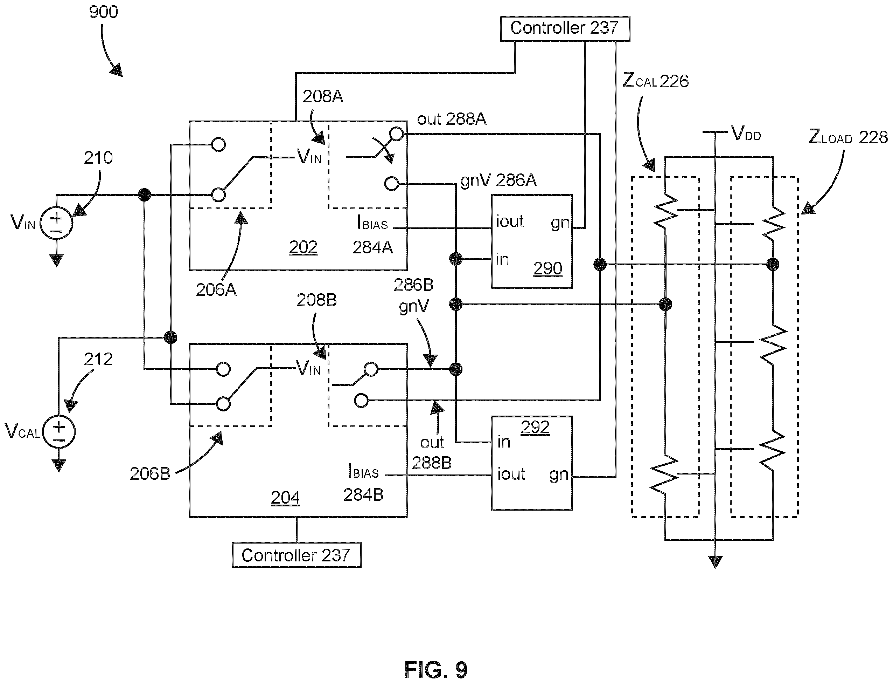

In some embodiments, the device uses a gain correction amplifier (e.g., a current biasing amplifier) as a control signal to vary the bias point of the transconductance amplifier, until the voltage across the calibration load reaches the target voltage and/or satisfies one or more criteria, include a criterion that is satisfied when the target voltage settles within a threshold voltage (e.g., +/- 10mV) of the target voltage (e.g., 200mV when a 10mV offset is applied across the amplifier inputs). FIG. 9 illustrates an example parallel transconductance amplifier topology including gain correction circuitry. For example, in FIG. 9, amplifier 290 provides a current bias to the first amplifier 202 (from "iout" terminal), and amplifier 292 provides a current bias to the second amplifier 204 (from "iout" terminal), based upon the voltages measured across the calibration load 228 during respective gain correction subphases.

In some embodiments, the transconductance amplifier topology (or a device including the transconductance amplifier topology) maintains the zero-offset and/or current biasing of the second amplifier 204 determined during the one or more calibration phases (e.g., during auto-zeroing and/or gain correction subphases) while the second amplifier 204 later "runs" (e.g., performs transconductance measurements (102c)). For example, a voltage stored across correction capacitance (e.g., determined during the auto-zeroing subphase) is stored and/or a bias point of the amplifier is maintained by connecting the correction capacitance to a trimming terminal, and output stage, or an input stage of the amplifier (e.g., determined during the gain correction subphase). For example, the voltage across capacitors 260, 262 illustrated in FIG. 8 is detected and held during the gain correction subphase for determining gain correction bias current, and/or held through the operational phase of the second amplifier (e.g., or transconductance amplifier 202). Such corrections (e.g., the auto-zero held voltage and/or amplifier bias current I_{BIAS} can be applied to the second amplifier such that the amplifier output voltage matches, or nearly matches a target voltage (e.g., within a threshold, such as 0.5%, 1%, 2%, or other suitable threshold, of the target voltage) when a voltage is applied to the inputs of the calibrated amplifier. After compensating for any input offset and gain drift (e.g., performed during steps 102a and steps 102b), the amplifier is configured for transconductance operations to convert voltage input signals to current output signals.

As described herein, when the first amplifier 202 performs the one or more calibration phases and the second amplifier 204 performs the transconductance operation. The switching circuitry included in the transconductance amplifier topology (or in a device including the transconductance amplifier topology) is configured in a third configuration. The third configuration is similar to the first configuration, but swapping the operation of the first amplifier 202 and the second amplifier 204. In the third configuration, the one or more input switches and the one or more output switches are arranged to couple the second amplifier 204 between the input and output of the transconductance amplifier topology. For example, the input represented by V_{IN} 210 is coupled differentially to the input terminals of second amplifier 204 using switches 218 and 220; the output, represented by V_{OUT} 211 is coupled to the output terminal of second amplifier 204 using switch 224 and coupled to output load 226 (Z_{LOAD}). In some embodiments, Vᵢₙ 210 is a voltage source representative of an input voltage that the electronic device 200 converts to a current. It is understood that Vᵢₙ 210 is merely exemplary of a voltage that may be sensed, and that the input voltage may include different or more circuitry than the schematic voltage source. For example, Vᵢₙ 210 optionally corresponds to an output voltage generated by a direct current to direct current (DC-DC) converter, a low-dropout regulator, and/or the like that is coupled to the electronic device 200. Additionally or alternatively, Vᵢₙ 210 optionally corresponds to a voltage formed across a resistor included in a SMPS, such as a current sensing shunt resistor.

In a similar manner, mirroring FIG. 2, in the third configuration, during the autozeroing operation for the first amplifier, one or more input switches, such as switch 234, are arranged to couple (e.g., short) the input terminals of the first amplifier 202 and one or more output switches included in the switching circuitry can be configured to couple the output of the first amplifier 202 to an auto-zero amplifier 241 and to one or more compensation capacitors (e.g., similar to capacitors 860, 862). The details of auto-zeroing are not repeated here for brevity. Similar to the second configuration shown in FIG. 3, in a fourth configuration, the inputs of the first amplifier 202 are coupled to a reference voltage V_{cal} 212 using switches 214 and 216 and an output of the transconductance amplifier is coupled to an output load (e.g., an attenuation network, such as including the calibration load 228) using switch 222. The details of the gain correction operation are not repeated for the first amplifier 202, but the first amplifier 202 is biased using biasing circuitry 230 using a control signal from controller 237. During the fourth configuration, the second amplifier 204 remains in the configuration for transconductance operation (e.g., same as the third configuration, not repeated for brevity).

Although FIGs. 2-3 illustrate separate auto-zeroing amplifiers 241 and 243 dedicated for first amplifier 202 and second amplifier 204, respectively, an alternative embodiments can use a single auto-zeroing amplifier that is switched between the first amplifier 202 and second amplifier 204 depending on which amplifier is configured for the auto-zeroing operation (e.g., first configuration couples a shared auto-zeroing amplifier to the second amplifier 204 and third configuration couples the shared auto-zeroing amplifier to the first amplifier 202).

It is understood that the electronic device 200 can include a greater number of switches, a fewer number of switches, and/or implemented using switches with a greater number of poles and/or throws or a fewer number of poles and/or throws, such that the transconductance amplifiers described herein may be coupled to input voltage(s), may be coupled to calibration voltages, may be shorted at respective inputs, may be coupled to calibration loads, and/or may be coupled to working loads as described further herein. In some embodiments, the switches are implemented including field effect transistors (FETs), complementary metal-oxide-semiconductor field-effect transistor (CMOS) switches, multiplexors, and/or other types of switches.

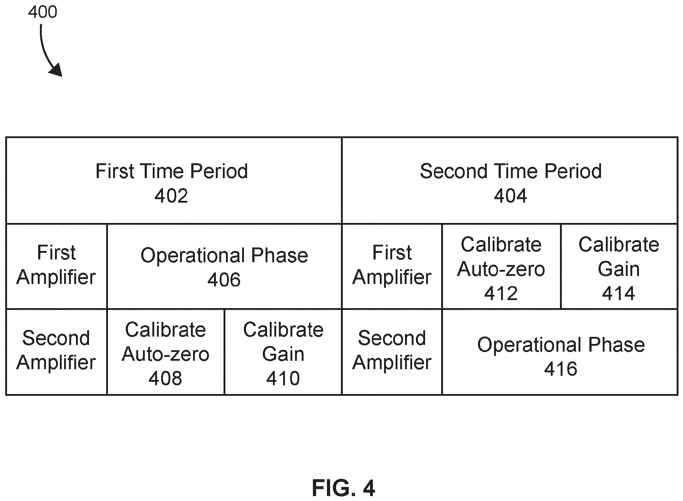

FIGs. 4-6 illustrates tables and timing diagrams representing configurations and operations of the transconductance amplifier topology according to embodiments of the disclosure. Table 400 illustrates two time periods including a first time period 402 and a second time period 404. During first time period 402, corresponding to the configurations of first amplifier 202 in FIGs. 2 and 3, first amplifier 202 is configured in an operational phase 406 for transconductance operations to convert an input voltage at the inputs of the transconductance amplifier topology to an output current. During first time period 402, corresponding to the configurations of second amplifier 204 in FIGs. 2 and 3, second amplifier 202 is configured in one or more calibration phases including an auto-zeroing subphase and a gain correction subphase. For example, during a first portion of first time period 402, corresponding to the configurations of second amplifier 204 in FIG. 2, second amplifier 204 is configured in an auto-zero calibration subphase 408 to perform auto-zeroing operation. During a second portion of first time period 402, corresponding to the configurations of second amplifier 204 in FIG. 2, second amplifier 204 is configured in a gain calibration subphase 410 to perform gain correction operations.

During the second time period 404, the configurations and phases of the amplifiers are swapped. For example, first amplifier 202 is configured to perform one or more calibration operations including an auto-zero subphase 412 and a gain calibration subphase 414. Concurrently, the second amplifier 204 is configured in an operational phase 416 for transconductance operations between the input and output of the transconductance amplifier topology.

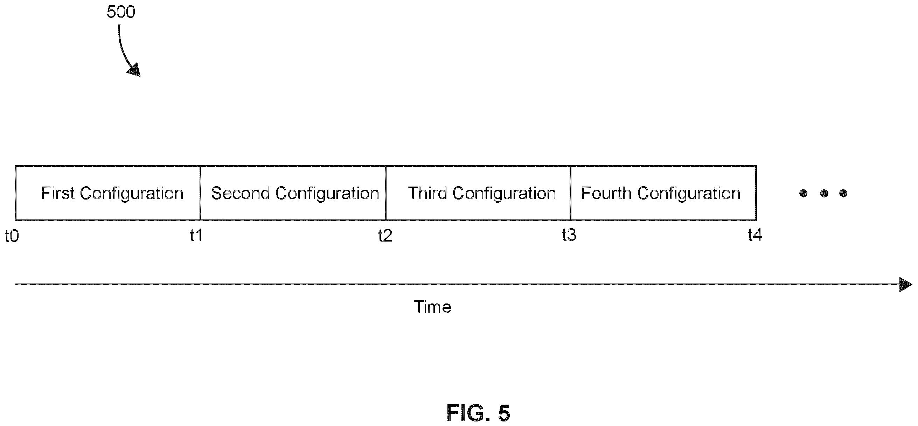

FIG. 5 illustrates timing diagram 500 of a transconductance amplifier topology according to embodiments of the disclosure. Referring back to the description of FIGs. 2-3, the transconductance amplifier topology can include four configurations for the switching circuitry. For example, as described above, during the first time period 402 (between t0 and t2), the first amplifier 202 can be configured in the first configuration and in the second configuration for the switching circuitry corresponding to an operational phase 406 to perform transconductance operations between the input and output. During the second time period 404 (between t2 and t4), the second amplifier 204 can be configured in the third configuration and in the fourth configuration for the switching circuitry corresponding to an operational phase 416 to perform transconductance operations between the input and output. During the first portion of the first time period 402 (between t0 and t1), the second amplifier 204 can be configured in the first configuration for the switching circuitry for an auto-zero calibration subphase 408 to perform auto-zeroing operations, and during the second portion of the first time period 402 (between t1 and t2), the second amplifier 204 can be configured in the second configuration for the switching circuitry corresponding to gain correction subphase 410 to perform gain correction operations. During the first portion of the second time period 404 (between t2 and t3), the first amplifier 202 can be configured in the third configuration for the switching circuitry for an auto-zero calibration subphase 412 to perform auto-zeroing operations, and during the second portion of the second time period 404 (between t3 and t4), the first amplifier 202 can be configured in the fourth configuration for the switching circuitry corresponding to gain correction subphase 414 to perform gain correction operations.

In some embodiments, the operational phase is maintained for the period of time 402, such as 500ns. It is understood that 500ns is an example, but the operational phase is optionally maintained for a greater period of time than 500ns, (e.g., 750ns, 1000ns, or 1500ns) or for a lesser period of time (e.g., 100ns, 250ns, 400ns) depending on the speed requirements of the application. In some embodiments, operational phase is maintained for the second period of time 404, which is optionally the same 500ns period as the first period of time 402 (or a different period of time, greater or lesser). The duration of the auto-zero subphase and the gain correction subphase together can be the same duration or less than the duration of the operation phase. In some embodiments, the duration of the auto-zero subphase and the gain correction subphase are equal. In some embodiments, the duration of the auto-zero subphase and the gain correction subphase are unequal.

In some embodiments, the frequency at which the switch configurations of electronic device 200 vary are based upon a switching frequency of related circuitry, such as a switched mode power supply (SMPS) that is coupled to an input of electronic device 200. For example, in FIG. 5, the period of time for auto zero and the period of time for gain correction can correspond to a reciprocal of the switching frequency of a SMPS (e.g., for 250 ns each, 500 ns each, etc.).

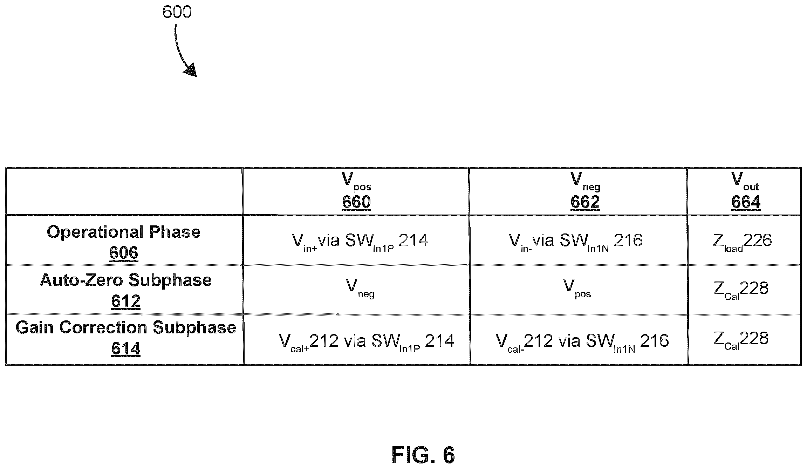

FIG. 6 illustrates a table 600 including switching configuration of a transconductance amplifier topology according to embodiments of the disclosure. For example, FIG. 6 illustrates various phases, and corresponding configurations of switches of the first amplifier 202 in FIG. 2. It is understood that the second amplifier 204 can also be configured per table 600 (swapping the operation and calibration phases with first amplifier 202), by applying the switch settings of the first amplifier 202 in table to the corresponding switches of second amplifier 204.

During operational phase 606 (e.g., corresponding to operational phase 406), the electronic device 200 and/or transconductance amplifier topology such as shown in FIG. 2 can be configured to obtain transconductance measurements using first amplifier 202 by coupling the input nodes for an input voltage to the terminals of first amplifier 202 using coupling switch 214 and switch 216. For example, the non-inverting terminal, Vₚₒₛ 660, of the first amplifier 202 is coupled to Vᵢₙ₊, which represents the positive input terminal of the transconductance amplifier topology. The inverting terminal, V_{neg} 662, of the first amplifier 202 is coupled to Vᵢₙ₋, which can be the negative terminal the transconductance amplifier topology. Switch 234 remains open to avoid shorting the inverting and non-inverting terminals of first amplifier 202. Additionally, the operational phase 606 includes coupling an output Vₒᵤₜ 664 of the first amplifier 202 to load 226 (Z_{LOAD}) via switch 222.

During auto-zero subphase 612 (e.g., corresponding to auto-zero subphase 412), the non-inverting and inverting terminals, (the first terminal, Vₚₒₛ 660 and the second terminal, V_{neg} 662, respectively), are shorted with switch 234 and decoupled from the input voltage (and the calibration input voltage). The output of first amplifier 202 is decoupled from the output load 226, and can be terminated, left floating, and/or coupled to a calibration load 228 using switch 222.

During gain correction subphase 614 (e.g., corresponding to gain correction subphase 414), switch 214 and switch 216 couple the inputs of the first amplifier 202 to respective nodes across a calibration voltage, V_{cal} 212. For example, a first terminal, Vₚₒₛ 660 of the first amplifier 202 is coupled to a first terminal of a calibration voltage, and a second terminal, V_{neg} 662 of the first amplifier 202 is coupled to a second terminal of the calibration voltage. The output of the first amplifier 202 is coupled to the calibration load 228 using output switch 222.

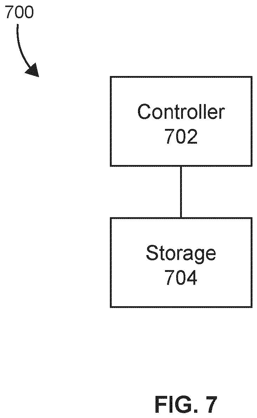

FIG. 7 illustrates an example controller in communication with storage according to embodiments of the disclosure. Circuitry 700 can represent a controller 702 including integrated storage 704, and/or a controller 702 that is communicatively coupled to the storage 704. In some embodiments, the controller 702 executes one or more instructions stored in the storage 704 (e.g., in memory) to cause an electronic device, such as electronic device 200, or the transconductance amplifier topology described herein, to perform one or more operations. Such operations can include configuring the constituent amplifiers in the transconductance amplifier topology in the various operational modes (e.g., switching the first amplifier and second amplifier between performing transconductance operations and one or more calibration operations) using one or more input switches 206 and/or output switches 208. For example, controller 702 optionally corresponds to controller 237 and/or 239 in FIG. 2-3 to provide control to switches 206 and/or 208. Additionally or alternatively, the operations can include controlling connections and control signals (e.g., using controller 237 and/or 239) to allow for auto-zeroing and gain calibration using digital and/or analog circuitry (e.g., auto-zeroing using one or more analog auto-zeroing amplifiers 241, 243 and correction capacitors 860, 862, biasing using analog biasing provided by biasing circuitry 230 and/or biasing circuitry 232, etc.) to reduce or eliminate and input offset and to change a bias/gain of such one or more amplifiers. In some embodiments, controller 702 is a hardwired controller (which may not include storage 704) or a processor.

In some example embodiments, these instructions/steps are implemented as functional and software instructions. In other embodiments, the instructions can be implemented either using logic gates, application specific chips, firmware, as well as other hardware forms.

When the instructions are embodied as a set of executable instructions in a non-transitory computer-readable or computer-usable media which are effected on a computer or machine programmed with and controlled by said executable instructions. Said instructions are loaded for execution on a processor (such as one or more CPUs). Said processor includes microprocessors, microcontrollers, processor modules or subsystems (including one or more microprocessors or microcontrollers), or other control or computing devices. A processor can refer to a single component or to plural components. Said computer-readable or computer-usable storage medium or media is (are) considered to be part of an article (or article of manufacture). An article or article of manufacture can refer to any manufactured single component or multiple components. The non-transitory machine or computer-usable media or mediums as defined herein excludes signals, but such media or mediums may be capable of receiving and processing information from signals and/or other transitory mediums.

FIG. 8 illustrates a transconductance amplifier including auto-zeroing circuitry according to embodiments of the disclosure. Electronic device 800 includes a transconductance amplifier 202 and an auto-zero amplifier 241, which can be similar to or the same as the amplifiers described with reference to other figures described herein. It is understood that description of the amplifier 202 can similarly apply to amplifier 204, and that description of amplifier 241 can similarly apply to amplifier 243. In some embodiments, amplifier 202 can include input switches 214 and 216, which can toggle between a calibration voltage and an input voltage. In some embodiments, a controller such as controller 237 and/or controller 702 changes switching configurations and/or coupling of the inputs and outputs of amplifier 202. For example, the inputs of amplifier 202 can be shorted during an auto-zero subphase. In some embodiments, the amplifier 202 includes output switches that couple an output stage of the amplifier 202 to a calibration load 228 and/or a load 226. For example, switch 280 can couple the output stage to the calibration load 228, and switch 282 can couple the output stage to the load 226. It is understood that description of gain correction amplifiers and/or circuitry can be coupled to the electronic device 800 to change the bias of transconductance amplifier 202, as described with reference to FIG. 9.

In some embodiments, as described previously, electronic device 800 can be configured in an auto-zero subphase. For example, the input switch 214 can couple a first input ("inp") of amplifier 202 to a second input ("inn") of the amplifier via switch 216, and additional or alternative switches. During the auto-zero subphase, an autozero signal 272 can be asserted, and a gain-voltage enable signal 274 can be held low (not asserted). Due to the assertion of autozero signal 272, switch 284 can be closed, coupling a measurement node ("cc") to a compensation capacitor 260. Additionally or alternatively, the assertion of autozero signal 272 can enable the switches 276 and 278, which can be output switches allowing current to flow through a current mirror included in amplifier 202 through the capacitors 262 and/or 260, which can be another compensation capacitor. In some embodiments, the auto zero-amplifier 241 facilitates charging current through the capacitors 262 and/or 260, changing bias currents applied to amplifier 202 until a voltage difference between the inputs of amplifier 202 is less than a threshold voltage. As described previously, the voltages across capacitors 260 and/or 262 can be the same, or nearly the same, as the analog voltages and/or currents settle in response to shorting the inputs of the amplifier 202.

In some embodiments, during the auto-zero subphase, one or more outputs switches can be configured to couple and/or de-couple the amplifier 202 to and/or from one or more loads. For example, output switch 280 can be left open, and/or can couple a node on a high-side of switch 276 or a low-side of switch 278 to an output calibration node (e.g., "gnv"). In some embodiments the output switch 282 can be asserted based upon a logical combination of other signal. For example, logic gate 270 (e.g., an XOR gate) can assert low when autozero signal 272 or gain voltage enable signal 274 are logically high. Accordingly, the switch 282 can open leaving an output voltage node (e.g., "out") left floating.

In some embodiments, following the auto-zero subphase, the electronic device 800 can perform a gain correction subphase. For example, the switch 214 and switch 216 can couple inputs of the amplifier 202 to input voltage nodes, and decouple the inputs from a calibration voltage node. Additionally, the inputs of the amplifier 202 can be disconnected, preventing shorting of the inputs that was used during the auto-zero subphase, as illustrated in FIG. 8.

In some embodiments, during the gain correction subphase, the auto-zero amplifier 241 is configured differently than during the auto-zero subphase. For example, the switches 276, 278, and/or 284 can open when auto-zero signal 272 is brought to a logical low, allowing capacitors 260 and 262 to hold a voltage-and thereby a bias of amplifier 202-that was established during the auto-zero subphase.

In some embodiments, the electronic device 800 couples an output of the amplifier 202 to a gain voltage node. For example, gain-voltage enable signal 274 can be asserted, causing a calibration output node ("gnv") to be coupled to a node situated at the output of amplifier 202. As described herein, the calibration output node can be coupled to a calibration load as described with reference to FIGs. 2, 3, and 9, while gain correction amplifiers change a bias of the amplifier 202 (described further with reference to FIG. 9, and at least partially not shown in FIG. 8). In some embodiments, until the controller in communication with electronic device 800 transitions from the gain correction subphase to the operational phase of the electronic device 800, the bias and therefore transconductance of amplifier 202 can be changed. For example, the bias can be changed until an output voltage measured across the calibration load coupled to the calibration output node satisfies one or more criteria (e.g., the output voltage is within a threshold voltage of a target voltage (e.g., 0.01, 0.1, 1, or 5mV of 10, 50, 100, 150, 200, 300, 500, or 1000mV).

In some embodiments, after the auto-zero subphase and gain correction subphase are complete, the amplifier of electronic device 800 is reconfigured to perform an operational phase. For example, the input switches 214 and 216 can be coupled to nodes across an input voltage as described with reference to FIGs. 2 and 3. Additionally, the autozero signal 272 and the gain voltage enable signal 274 can be brought low by the controller, causing the output of the logic gate 270 to driven to a logical high. Accordingly, at the output of electronic device 800, the switch 280 may disconnect the calibration output node from the output stage of amplifier 202, and may close the working output node (e.g., "out") via switch 282. In some embodiments, during the operational phase, the biasing determined and applied by auto-zero amplifier 241 during the auto-zero subphase is maintained, and the gain offset correction and/or biasing associated with the gain offset correction during the gain correction subphase are maintained. For example, the capacitors 262 and 260 continue to hold voltages similar to or the same as established during the auto-zero subphase.

Therefore, the amplifier 202 can facilitate transconductance measurements during the operational phase in accordance with biasing established during auto-zero and/or correction subphases. In some embodiments, while the amplifier 202 is performing the auto-zero and/or gain correction, a second amplifier (e.g., amplifier 204) facilitates transconductance measurements. In some embodiments, while the amplifier 202 is facilitating the transconductance measurements, the amplifier 204 performs auto-zero and/or gain correction subphases, using circuitry similar to or the same as described with reference to amplifier 202.

FIG. 9 illustrates a parallel transconductance amplifier topology including gain correction circuitry. For example, the electronic device 900 can include amplifier 202 and amplifier 204, which can be alternatively configured for the operational phase or the calibration subphases including auto-zeroing and/or gain correction described herein. For example, controller 237 can control switches included in the electronic device 900 to perform the various operations described herein. For example, controller 237 may control the switching of input switch 206A and output switch 208A included in amplifier 202, and can control the input switch 206B and/or the output switch 208B included in amplifier 204.

In some embodiments, the controller 237 additionally controls the enabling and/or operations of gain correction amplifiers. For example, amplifier 290 can be a first gain correction amplifier configured to change a bias-and thereby transconductance-of the amplifier 202 via an I_{bias} terminal 284A of amplifier 202. Similarly, amplifier 292 can be a second gain correction amplifier configured to change a bias of amplifier 204 via an I_{bias} terminal 284B of amplifier 204. It is understood that auto-zero circuitry may be included in, or external from but in communication with, the amplifiers 202 and 204 (not shown in FIG. 9 for simplicity of illustration). In some embodiments, the amplifiers 290 and/or 292 are differential amplifiers that measure a difference between the gain-voltage output of amplifier 202 and amplifier 204, respectively, relative to a reference voltage (e.g., a 100mV, 200mV, 300mV, 500mV, or 1V DC reference). In some embodiments, the amplifiers 290 and/or 292 converts the differential output to a current signal, which is furnished to the amplifiers 202 and/or 204 respectively, changing a biasing of the recipient amplifiers.

In FIG. 9, the amplifier 202 is configured in an operational phase of operation, and amplifier 204 is configured in a gain correction phase of operation. For example, the input switch 206A allows coupling of the input voltage 210 to the input stage(s) of the amplifier 202, and the output switch 208A is configured coupling Z_{load} 228 to the output 288A of amplifier 202 (and not to a gain-voltage output 286A). Concurrently, amplifier 204 can be coupled to V_{cal} 212 via input switch 206B, and can generate an output voltage across a portion of Z_{cal} 228 via output switch 208B via gain-voltage output 286B (and is not coupled to output 288B).

By configuring the transconductance amplifiers to perform calibration phase(s), electronic device 200 reduces the need for trimming circuitry required to accommodate for potential drifts in operating ranges of the amplifiers, thereby reducing manufacturing complexity, board and/or package space, and overall costs associated with electronic device 200. In some embodiments, the calibration subphase can be performed once or periodically. For example, electronic device 200 can be coupled to a switched mode power supply (SMPS), and perform calibration of a respective transconductance amplifier during one or more charge and/or discharge cycles of the SMPS. Thus, the calibration can be performed during a period of time that corresponds to the switching frequency of the SMPS. Additionally or alternatively, the electronic device 200 can perform the calibration subphase of a respective amplifier in response to initiating a transconductance measurement configuration of another amplifier. Because the calibration can include analog circuitry (e.g., in addition to in the alternative to digitally sampled, and digitally synthesized signals) for adjusting input offset and bias current, electronic device 200 can rapidly respond to swings in input signals, without occupying an excessive footprint in a circuit board and/or package including electronic device 200.

In view of the embodiments described herein, it is understood that the devices, systems, and methods can offer significant improvement over conventional transconductance amplification solutions. In particular, the devices described herein can provide system bandwidths that exceed 5, 10, 15, 20, 25, 30, 35, 40, and/or 50 MHz, and can reduce degradations in gain linearity. In contrast with conventional solutions, the embodiments described herein may provide for continuous transconductance operation despite rapid fluctuations in input signals due to the switching between a first and a second amplifier that may receive the input signals, and may provide a continuously accurate solution by rapidly performing calibration phase(s) of such amplifiers. Additionally, the embodiments described herein are flexible, and may not require excess circuitry to trim amplifiers.

In some embodiments, the topologies described herein may differ from the illustrated topologies. For example, the topologies optionally include a different number, arrangement, and/or type of switches, amplifiers, passive circuitry, and/or some combination thereof. Additionally or alternatively, auto-zeroing of a transconductance amplifier is optionally performed by one or more amplifiers and/or other circuits that are different from the auto-zero amplifiers illustrated in Fig. 8. Additionally or alternatively, the topologies can include one or more additional transconductance amplifiers which can perform calibration phase(s) while another transconductance amplifier performs an operational phase. In such examples, the one or more additional transconductance amplifiers can be configured in the operational phase to allow other transconductance amplifiers to perform calibration phase(s).

Some examples of the disclosure are directed to an electronic device. In some embodiments, the electronic device comprises a controller, a plurality of transconductance amplifiers including a first transconductance amplifier and a second transconductance amplifier, and switching circuitry including one or more first input switches, one or more second input switches, one or more first output switches, and one or more second output switches. In some embodiments, during a first period of time, the one or more first input switches are configured by the controller to operate the first transconductance amplifier in a transconductance operation phase by coupling an input of the first transconductance amplifier to an input voltage via the one or more first input switches, and by coupling an output of the first transconductance amplifier to an output load via the one or more first output switches, and the one or more second input switches are configured by the controller to operate the second transconductance amplifier in one or more calibration phases by decoupling an input of the second transconductance amplifier from the input voltage using the one or more second input switches and by decoupling an output of the second transconductance amplifier from the output load via the one or more second output switches.

Additionally or alternatively, during a second period of time, different form the first period of time, the one or more first input switches are configured by the controller to operate the first transconductance amplifier in the one or more one or more calibration phases by decoupling the input of the first transconductance amplifier from the input voltage using the one or more first input switches and by decoupling the output of the first transconductance amplifier from the output load via the one or more first output switches, and the one or more second input switches are configured by the controller to operate the second transconductance amplifier in the transconductance operation phase by coupling the input of the second transconductance amplifier to the input voltage via the one or more second input switches, and by coupling the output of the second transconductance amplifier to the output load via the one or more second output switches.

Additionally or alternatively, the electronic device can further comprise an auto-zeroing amplifier. In some embodiments, during a first sub-period of the first period of time the one or more second input switches are configured by the controller to operate the second transconductance amplifier in an auto-zeroing sub-phase of the one or more calibration phases by shorting a first terminal of the input of second transconductance amplifier to a second terminal of the input of the second transconductance amplifier and by storing a correction current using compensation capacitors associated with the auto-zeroing amplifier.

Additionally or alternatively, the electronic device can further comprise a gain correction amplifier. In some embodiments, during a second sub-period of the first period of time the one or more second input switches are configured by the controller to operate the second transconductance amplifier in a gain correction sub-phase of the one or more calibration phases by coupling the input of the second transconductance amplifier to a first calibration voltage and by adjusting a biasing of the second transconductance amplifier.

Additionally or alternatively, the electronic device can further comprise an input attenuation network, wherein the electronic device is further configured generate the first calibration voltage by coupling the input attenuation network to a supply voltage of the electronic device.

Additionally or alternatively, the first calibration voltage can correspond to a reference voltage generated by the electronic device.

Additionally or alternatively, the electronic device can comprise an output attenuation network. In some embodiments, the output attenuation network includes a calibration load coupled during the first period of time to output of the second transconductance amplifier during the one or more calibration phases.

Additionally or alternatively, the one or more calibration phases during the first time period can include an auto-zeroing subphase followed by a gain correction subphase.

Additionally or alternatively, the auto-zeroing subphase can include adjust a biasing of the second transconductance amplifier generated with the auto-zeroing amplifier until an output of the second transconductance amplifier satisfies one or more criteria.

Additionally or alternatively, the gain correction subphase can include supplementing the bias current of the second transconductance amplifier using gain correction circuitry based upon the adjusted biasing of the second transconductance amplifier generated with the auto-zero amplifier.

Additionally or alternatively, the during the first period of time the switching circuitry can be configured is a first configuration and a second configuration and during the second period of time the switching circuitry can be configured in a third configuration and a fourth configuration.

Additionally or alternatively, the first configuration for the switching circuitry can correspond to the transconductance operation phase for the first transconductance amplifier and an auto-zeroing sub-phase of the one or more calibration phases for the second transconductance amplifier, and the second configuration for the switching circuitry can correspond to the transconductance operation phase for the first transconductance amplifier and a gain correction sub-phase of the one or more calibration phases for the second transconductance amplifier.

Additionally or alternatively, the third configuration for the switching circuitry can correspond to the transconductance operation phase for the second transconductance amplifier and the auto-zeroing sub-phase of the one or more calibration phases for the first transconductance amplifier, and the fourth configuration for the switching circuitry can correspond to the transconductance operation phase for the second transconductance amplifier and the gain correction sub-phase of the one or more calibration phases for the first transconductance amplifier.

Additionally or alternatively, during the first period of time the switching circuitry can be configured in a first configuration and a second configuration and during the second period of time the switching circuitry is configured in a third configuration and a fourth configuration.

Additionally or alternatively, the first configuration for the switching circuitry can correspond to the transconductance operation phase for the first transconductance amplifier and an auto-zeroing sub-phase of the one or more calibration phases for the second transconductance amplifier, and the second configuration for the switching circuitry can correspond to the transconductance operation phase for the first transconductance amplifier and a gain correction sub-phase of the one or more calibration phases for the second transconductance amplifier.

Additionally or alternatively, a duration of the first period of time can correspond to a switching frequency of a power supply coupled to the electronic device.

Some embodiments of the disclosure are directed to a method comprising, during a first period of time, measuring transconductance using a first transconductance amplifier, and during the first period of time, concurrently calibrating a second transconductance amplifier while measuring the transconductance using the first amplifier, wherein the calibrating includes an auto-zero subphase and a gain correction subphase

Additionally or alternatively, the auto-zero subphase can include using analog circuitry included in the electronic device to change a bias of the second transconductance amplifier.

Additionally or alternatively, the method can further comprise, during a second period of time, measuring the transconductance using the second transconductance amplifier, wherein the of the second transconductance amplifier corresponds to the bias established during the auto-zero subphase, and during the second period of time, concurrently calibrating the first transconductance amplifier while measuring the transconductance using the second amplifier.

Additionally or alternatively the gain correction subphase can include using circuitry included in the electronic device to change a gain of the second transconductance amplifier until one or more criteria are satisfied.

Additionally or alternatively, the one or more criteria can be satisfied when a voltage generated by the second transconductance amplifier is within a threshold voltage of a target voltage.

Additionally or alternatively, the method can further comprise, during the first period of time, concurrently calibrating a third transconductance amplifier while measuring the transconductance using the first amplifier. In some embodiments, the calibrating includes the auto-zero subphase and the gain correction subphase.

The foregoing description has been described with reference to specific examples. It is understood that illustrative discussions above are not intended to be exhaustive or to limit the disclosure to the particular disclosed examples. Various modifications and variations are possible in view of the above disclosure. The examples were chosen and described in order to explain the principles of the disclosure and its practical applications, to thereby enable individuals skilled in the art to best use the disclosure and various described examples with various modifications suited to particular uses.

## Claims

1. An electronic device comprising:
a controller;
a plurality of transconductance amplifiers including a first transconductance amplifier and a second transconductance amplifier; and
switching circuitry including one or more first input switches, one or more second input switches, one or more first output switches, and one or more second output switches, wherein during a first period of time:
the one or more first input switches are configured by the controller to operate the first transconductance amplifier in a transconductance operation phase by coupling an input of the first transconductance amplifier to an input voltage via the one or more first input switches, and by coupling an output of the first transconductance amplifier to an output load via the one or more first output switches, and
the one or more second input switches are configured by the controller to operate the second transconductance amplifier in one or more calibration phases by decoupling an input of the second transconductance amplifier from the input voltage using the one or more second input switches and by decoupling an output of the second transconductance amplifier from the output load via the one or more second output switches.

2. The electronic device of claim 1, wherein during a second period of time, different from the first period of time:
the one or more first input switches are configured by the controller to operate the first transconductance amplifier in the one or more one or more calibration phases by decoupling the input of the first transconductance amplifier from the input voltage using the one or more first input switches and by decoupling the output of the first transconductance amplifier from the output load via the one or more first output switches, and
the one or more second input switches are configured by the controller to operate the second transconductance amplifier in the transconductance operation phase by coupling the input of the second transconductance amplifier to the input voltage via the one or more second input switches, and by coupling the output of the second transconductance amplifier to the output load via the one or more second output switches.

3. The electronic device of claim 1 or 2, further comprising an auto-zeroing amplifier, wherein during a first sub-period of the first period of time the one or more second input switches are configured by the controller to operate the second transconductance amplifier in an auto-zeroing sub-phase of the one or more calibration phases by shorting a first terminal of the input of second transconductance amplifier to a second terminal of the input of the second transconductance amplifier and by storing a correction current using compensation capacitors associated with the auto-zeroing amplifier.

4. The electronic device of any preceding claim, further comprising a gain correction amplifier, wherein during a second sub-period of the first period of time the one or more second input switches are configured by the controller to operate the second transconductance amplifier in a gain correction sub-phase of the one or more calibration phases by coupling the input of the second transconductance amplifier to a first calibration voltage and by adjusting a biasing of the second transconductance amplifier.

5. The electronic device of claim 4, further comprising an input attenuation network, wherein the electronic device is further configured generate the first calibration voltage by coupling the input attenuation network to a supply voltage of the electronic device.

6. The electronic device of claim 4 or 5, wherein the first calibration voltage corresponds to a reference voltage generated by the electronic device.

7. The electronic device of any preceding claim, further comprising an output attenuation network, wherein the output attenuation network includes a calibration load coupled during the first period of time to output of the second transconductance amplifier during the one or more calibration phases.

8. The electronic device of any preceding claim, wherein the one or more calibration phases during the first time period includes an auto-zeroing subphase followed by a gain correction subphase.

9. The electronic device of claim 8, wherein the auto-zeroing subphase includes adjusting a biasing of the second transconductance amplifier generated with an auto-zeroing amplifier until inputs of the second transconductance amplifier including the input satisfies one or more criteria.

10. The electronic device of claim 9, wherein the gain correction subphase includes supplementing the bias current of the second transconductance amplifier using gain correction circuitry based upon the adjusted biasing of the second transconductance amplifier generated with the auto-zero amplifier from the auto-zeroing subphase.

11. The electronic device of any preceding claim, wherein during the first period of time the switching circuitry is configured in a first configuration and a second configuration and during a second period of time the switching circuitry is configured in a third configuration and a fourth configuration.

12. The electronic device of claim 11, wherein the first configuration for the switching circuitry corresponds to the transconductance operation phase for the first transconductance amplifier and an auto-zeroing sub-phase of the one or more calibration phases for the second transconductance amplifier, and the second configuration for the switching circuitry corresponds to the transconductance operation phase for the first transconductance amplifier and a gain correction sub-phase of the one or more calibration phases for the second transconductance amplifier.

13. The electronic device of claim 11 or 12, wherein the third configuration for the switching circuitry corresponds to the transconductance operation phase for the second transconductance amplifier and the auto-zeroing sub-phase of the one or more calibration phases for the first transconductance amplifier, and the fourth configuration for the switching circuitry corresponds to the transconductance operation phase for the second transconductance amplifier and the gain correction sub-phase of the one or more calibration phases for the first transconductance amplifier.

14. The electronic device of any preceding claim, wherein a duration of the first period of time corresponds to a switching frequency of a power supply coupled to the electronic device.

15. A method of operating an electronic device comprising:
during a first period of time, measuring transconductance using a first transconductance amplifier, and
during the first period of time, concurrently calibrating a second transconductance amplifier while measuring the transconductance using the first transconductance amplifier, wherein the calibrating includes an auto-zero subphase and a gain correction subphase.
